Europäisches Patentamt

European Patent Office

Office européen des brevets

(19)

(11) Numéro de publication : **0 632 279 A1**

# (12) DEMANDE DE BREVET EUROPEEN

(21) Numéro de dépôt : **94401492.7**

(22) Date de dépôt : **30.06.94**

(51) Int. Cl.⁶ : **G01R 29/027**

(30) Priorité : **02.07.93 FR 9308145**

(43) Date de publication de la demande :
**04.01.95 Bulletin 95/01**

(84) Etats contractants désignés :
**DE GB IT**

(71) Demandeur : **COMMISSARIAT A L'ENERGIE ATOMIQUE**
**31-33, rue de la Fédération**
**F-75015 Paris (FR)**

(72) Inventeur : **Trystram, Philippe**
**7, rue Casimir Brenier**
**F-38120 Saint Egreve (FR)**

(74) Mandataire : **Dubois-Chabert, Guy et al**
**c/o BREVATOME**
**25, rue de Ponthieu**
**F-75008 Paris (FR)**

(54) **Dispositif de mesure de la durée d'un intervalle de temps.**

(57)    L'invention concerne un dispositif de mesure de la durée d'un intervalle de temps entre un signal de début (D) et un signal de fin d'intervalle (F) à mesurer comprenant :

— un circuit numérique muni d'une première et d'une seconde horloges (C1, C2)), apte à compter le nombre d'impulsions d'horloge comprises entre le signal de début (D) et le coup d'horloge succédant au signal de fin d'intervalle (F) ;

— un circuit analogique, apte à mesurer le temps séparant le signal de début d'intervalle (D) de l'impulsion d'horloge suivante et à mesurer le temps séparant le signal de fin d'intervalle (F) de l'impulsion d'horloge suivante,

— un circuit de traitement, apte à déterminer la durée de l'intervalle de temps à partir des données fournies par le circuit numérique et celles fournies par le circuit analogique préalablement converties en données numériques.

Application notamment au domaine de la robotique.

FIG. 3

EP 0 632 279 A1

## Domaine technique

L'invention concerne un dispositif de mesure de la durée d'un intervalle de temps.

Le domaine de l'invention est celui d'une mesure de temps précise, de l'ordre de quelques dizaines de picosecondes de résolution, pour des intervalles de temps mesurés très grands, par exemple de l'ordre de la microseconde, cette mesure étant effectuée rapidement.

## Etat de la technique antérieure

Dans le domaine de la mesure de temps de grande précision, on fait appel à des techniques de moyennage ou d'autres procédés qui augmentent considérablement le temps d'acquisition de la valeur de la mesure par rapport au temps mesuré.

Le moyennage n'est possible que si le phénomène mesuré présente une stationnarité convenable relativement au temps de moyennage.

L'utilisation d'un vernier de fréquence tel que décrit dans l'article intitulé "The Vernier Time-Measuring Technique" de Robert G. Baron (Proceedings of the Ire, janvier 1957) recherche un battement et ainsi rallonge d'une quantité non négligeable le temps de mesure (5 microsecondes de temps de mesure pour une résolution de 20 picosecondes avec des horloges de 100 Megahertz). Ceci a pour effet de limiter le nombre de mesures possibles bien en deçà de la cadence de réalisation de certains événements.

Par ailleurs, les systèmes purement analogiques sont peu adaptés à la mesure de grands intervalles de temps, en raison de l'instabilité de la mémoire utilisée de tels intervalles (≧100ns), ou de la détérioration du signal pour les systèmes à circulation et coïncidence.

Dans le domaine de l'invention des événements successifs diffèrent et la vitesse de la mesure détermine la fréquence d'acquisition des images ; il est alors important qu'elle soit rapide (durée de la mesure ≦8μs→ fréquence≧ 125 kHz). Dans tous les cas, postérieurement à l'acquisition des paramètres de la mesure, il y a un calcul à réaliser qui nécessite un temps propre, qui peut être relativement indépendant de la technique de mesure située en amont. La fréquence de répétition dépend ainsi de la méthode de mesure du temps et de la conversion du résultat.

Un état de la technique antérieure est donné dans l'article intitulé "Review of Sub-Nanosecond Time-Internal Measurements" de Dan I. Porat (Stanford University).

Une demande de brevet français n°8 905 654 déposée le 28 Avril 1989 décrit un procédé de télémétrie par mesure de temps de vol et un dispositif pour la mise en oeuvre du procédé. La mesure de temps est faite selon la méthode d'interpolation-dilatation. La mise en application de ce procédé ne comprend pas de dispositif permettant d'éviter l'erreur de comptage d'un coup d'horloge dans certaines situations d'ambiguïté. Par ailleurs, la durée de la mesure est de 10 microsecondes sans compter les temps de calcul et de conversion.

L'objet de l'invention est de proposer un dispositif de mesure précise pour de grands intervalles de temps mesurés.

## Exposé de l'invention

L'invention concerne un dispositif de mesure de la durée d'un intervalle de temps entre un signal de début et un signal de fin d'intervalle à mesurer comprenant :

- un circuit numérique muni d'une horloge, apte à compter le nombre d'impulsions d'horloge comprises entre le signal de début et le coup d'horloge succédant au signal de fin d'intervalle ;
- un circuit analogique, apte à mesurer le temps séparant le signal de début d'intervalle de l'impulsion d'horloge qui lui succède et à mesurer le temps séparant le signal de fin d'intervalle de l'impulsion d'horloge qui lui succède et apte à convertir les données analogiques obtenus en données numériques ;
- un circuit de traitement, apte à déterminer la durée de l'intervalle de temps à partir des données fournies par le circuit numérique et celles fournies par le circuit analogique préalablement converties en données numériques ;

caractérisé en ce que le circuit numérique est muni d'une seconde horloge, dont les impulsions sont décalées d'une demi-période T par rapport à celles de la première horloge et des moyens aptes à déterminer lequel des comptages réalisés sur l'une des deux horloges est à prendre en compte de manière à résoudre toute situation d'ambiguïté qui pourrait conduire à une erreur de comptage d'une période d'horloge.

Dans une première réalisation, le signal de début d'intervalle est synchrone de la première horloge et le circuit numérique comprend :

- une bascule de type RS commandée par le signal de départ D sur son entrée SET, et par le signal de fin d'intervalle F retardé, après passage dans un circuit retardateur, sur son entrée RESET ;
- un premier bloc comportant :
  - un premier compteur,
  - une première bascule de type D,
  - un premier circuit ET ;
- un second bloc comportant :
  - un second compteur,
  - une seconde bascule de type D,
  - un second circuit ET ;
- un circuit doté d'une mémoire, apte à effectuer une fonction OU pour détecter laquelle d'entre les sorties des bascules a basculé la première.

Dans une seconde réalisation, le signal de début d'intervalle n'est pas synchrone de la première horloge, et le circuit numérique comprend :

- une bascule de type RS commandée par le signal de début retardé après passage dans un premier circuit retardateur sur son entrée SET, et par le signal de fin d'intervalle retardé, après passage dans un circuit retardateur de retard identique à celui du premier circuit retardateur sur son entrée RESET ;
- un premier bloc comportant :
  - un premier compteur,
  - une première bascule de type D,
  - un premier circuit ET,
  - un premier circuit OU,
  - un second circuit ET,
  - un moyen de mise en forme temporelle du signal ;
- un second bloc comportant :
  - un second compteur,
  - une seconde bascule de type D,
  - un troisième circuit ET,
  - un second circuit OU,
  - un quatrième circuit ET,
  - un moyen de mise en forme temporelle du signal ;
- un circuit doté d'une mémoire, apte à effectuer une fonction OU pour détecter laquelle d'entre les sorties des bascules a basculé la première.

Le circuit de mesure analogique comprend un circuit de mémorisation et de conversion en amplitude de tension suivi d'un circuit de conversion analogique/numérique.

Dans la première réalisation, dans le premier bloc, le premier compteur reçoit sur son entrée autorisation CE un ordre de comptage venant de la bascule de type RS, les données en sortie du premier compteur sont transmises au circuit de traitement par l'intermédiaire d'un circuit aiguillage commandé par un circuit OU, la première bascule de type D reçoit le signal de fin d'intervalle F sur son entrée D et la première horloge sur son entrée horloge, le premier circuit ET réalise la fonction ET de la sortie de la première bascule de type D et de la seconde horloge.

Dans la seconde réalisation, dans le premier bloc, le premier compteur reçoit sur son entrée autorisation CE un ordre de comptage venant de la bascule de type RS. Les données en sortie du premier compteur sont transmises au circuit de traitement par l'intermédiaire d'un circuit aiguillage commandé par un circuit OU. La première bascule de type D, commandée par un premier circuit OU reçoit le signal de début et le signal de fin d'intervalle sur son entrée D et la première horloge sur son entrée horloge. Le premier circuit ET réalise la fonction ET de la sortie de la première bascule de type D et de la seconde horloge.

Dans la première réalisation, dans le second bloc, le second compteur reçoit sur son entrée autorisation CE un ordre de comptage venant de la bascule de type RS, les données de ce compteur sont transmises au circuit de traitement par l'intermédiaire d'un circuit d'aiguillage, la seconde bascule de type D reçoit le signal de fin d'intervalle sur son entrée D et la seconde horloge sur son entrée horloge. Le second circuit ET réalise la fonction ET entre la sortie de cette bascule D et la première horloge.

Dans la seconde réalisation, dans le second bloc, le second compteur reçoit sur son entrée autorisation un ordre de comptage venant de la bascule de type RS. Les données de ce compteur sont transmises au circuit de traitement par l'intermédiaire d'un circuit d'aiguillage. La seconde bascule de type D, commandée par un second circuit OU reçoit le signal de début et le signal de fin d'intervalle sur son entrée D et la seconde horloge sur son entrée horloge. Le second circuit ET réalise la fonction ET entre la sortie de cette bascule D et la première horloge.

Le circuit doté d'une mémoire a sa sortie qui commande le fonctionnement du circuit aiguillage pour obtenir la lecture du compteur dont la bascule de type D associée n'a pas basculée la première. Ce circuit est relié par une bascule au circuit de traitement et lui fournit les données relatives au compteur sélectionné. Il détecte la première des bascules de type D qui a basculé et autorise la lecture du compteur dont la bascule de type D n'a pas changé d'état. Cette bascule est une bascule de type RS qui reçoit sur son entrée SET le signal de fin d'intervalle retardé, et sur son entrée RESET un circuit OU connecté aux sorties des circuits ET. Sa sortie délivre un signal au circuit de mémorisation et de conversion en amplitude de tension.

Dans la première réalisation, le circuit analogique comporte un circuit de mémorisation qui comprend :

- deux générateurs aptes à fournir des courants égaux en amplitude et de signes opposés ;
- un condensateur ;
- deux interrupteurs aptes à commuter les courants issus des deux générateurs sur le condensateur et qui sont commandés par la bascule de type RS, recevant le signal de fin d'intervalle retardé sur son entrée SET et le signal de début d'intervalle sur entrée RESET.

Dans la seconde réalisation, le circuit analogique comporte un circuit de mémorisation qui comprend :

- deux générateurs aptes à fournir des courants égaux en amplitude et de signes opposés ;
- un condensateur ;
- deux interrupteurs aptes à commuter les courants issus des deux générateurs sur le condensateur et qui sont commandés par les bascules de type RS, et recevant pour la première, le signal de fin d'intervalle retardé sur son entrée SET et le signal OU connecté sur son entrée RESET et pour la deuxième, le signal de début d'intervalle retardé sur son entrée SET et le OU connecté sur son entrée RESET.

Le signal de fin d'intervalle est retardé d'une durée suffisamment grande par rapport au temps de propagation unitaire des opérateurs utilisés pour assurer un décalage de prise en compte par l'horloge de chacune des voies de comptage entre le compteur et la bascule D associée. D'autre part, cette durée doit avantageusement demeurer courte devant la période d'horloge.

Par exemple, le signal de fin d'intervalle F est retardé d'un délai de 3tpd (tpd=temps de propagation).

Il en est de même pour le signal de début d'intervalle, dans la seconde variante.

Le dispositif de l'invention peut être utilisé par exemple pour la réalisation d'un capteur d'images pour la robotique qui requiert un grand nombre de mesures précises par seconde, mesures dites de "temps de vol", d'une impulsion laser, le temps à mesurer étant celui mis par une impulsion lumineuse pour aller et venir d'un émetteur à un récepteur en ayant subi une réflexion sur une cible (temps de vol).

Brève description des dessins

- Les figures 1 à 3 illustrent le dispositif de l'invention, et le fonctionnement de celui-ci ;
- la figure 4 illustre le fonctionnement d'une variante du dispositif de l'invention ;
- la figure 5 illustre une variante de réalisation du dispositif de l'invention.

Exposé détaillé de modes de réalisation

Pour mesurer la durée d'un intervalle de temps déterminé, le dispositif de l'invention mesure la partie grossière de l'intervalle de temps de manière numérique, et la partie fine de manière analogique. Les paramètres ainsi acquis sont recombinés pour obtenir le résultat. La mesure de temps est ainsi obtenue en associant une grandeur numérique sous la forme d'un nombre de périodes d'horloge comptées, et une grandeur analogique par la conversion d'un temps en amplitude de tension.

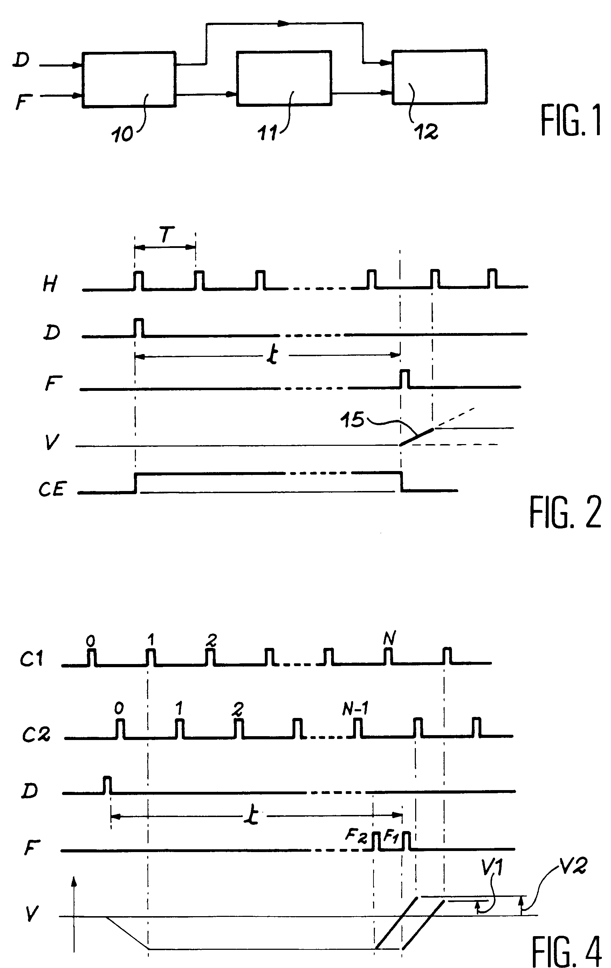

Le dispositif de mesure de l'invention, représenté à la figure 1 comprend donc un circuit de mesure numérique 10 recevant ces impulsions D et F de début et de fin d'intervalle, dont l'une des sorties est reliée directement à un circuit de traitement 12, et dont l'autre sortie est reliée à ce circuit 12 au travers d'un circuit de mesure analogique 11.

Sur le diagramme de fonctionnement du dispositif de l'invention, représenté sur la figure 2, on a l'impulsion de départ D, synchrone d'un signal d'horloge H récurrent d'impulsions de période T et l'impulsion de fin d'intervalle à mesurer F.

Dès le front avant de l'impulsion D, les impulsions de signal horloge H sont comptées dans un compteur, le signal F arrête le compteur et déclenche une rampe de tension 15 qui est elle-même arrêtée par le front avant de l'impulsion du signal horloge suivant le signal F. On note que, à la différence du signal D, le signal F survient de manière aléatoire par rapport au signal horloge. Le signal CE est le signal de validation du compteur d'impulsions horloge. L'amplitude V atteinte par la rampe correspond à une fraction K de la période T, telle que :

$$V = f(kT) \quad (1)$$

Si le contenu du compteur est N, l'expression de la durée de l'intervalle de temps cherché est :

$$t = (N + 1 - K)\, T \quad (2)$$

La saisie des grandeurs V et N est faite en temps réel pendant la mesure, l'équation (1) permet d'obtenir K par l'intermédiaire d'une conversion analogique/numérique ; l'équation (2) donne le temps exprimé sur la base de la période horloge. La grandeur analogique V est obtenue par commutation d'un courant dans une capacité pendant un temps KT. La grandeur numérique désirée est obtenue dans le compteur.

La largeur des signaux D et F est comprise entre 1/2 et une période d'horloge de façon à avoir une probabilité de coïncidence du front d'horloge et des signaux égale à un. Si les signaux sont trop étroits, l'un d'entre eux F ou D (voire les deux) risque de ne pas être comptabilisé.

En ce qui concerne le résultat de l'acquisition numérique on peut faire les observations suivantes: lorsque les signaux F et H sont présents simultanément, le compteur peut compter l'impulsion d'horloge alors que le signal F aurait dû l'interdire. Il y a une situation d'ambiguïté qui peut conduire à une erreur d'une période d'horloge.

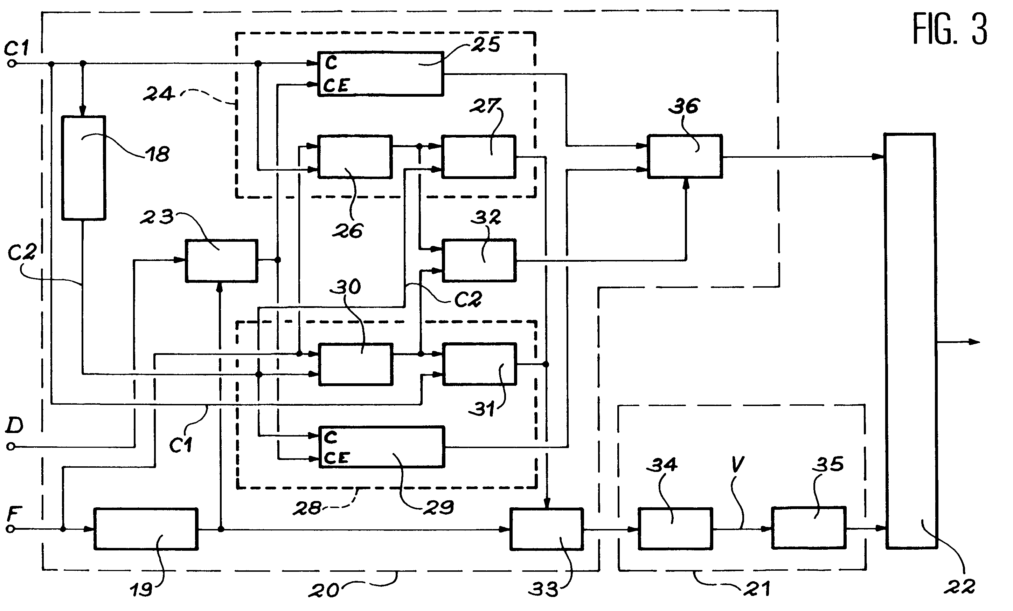

De façon à éviter cette ambiguïté. Le dispositif de l'invention, représenté sur la figure 3, comprend deux voies de comptage de deux signaux horloge C1 et C2 de même fréquence, décalés en temps d'une demi-période (circuit retard 18). Le résultat de mesure pris en compte est celui de la voie où il n'y a pas pu avoir ambiguïté. En outre dans chaque voie on décale l'instant de présence du signal F (circuit retard 19) sur les circuits qu'il commande.

Ce dispositif comprend : un circuit numérique 20, un circuit analogique 21 et un circuit de traitement 22.

Le circuit numérique 20 est muni d'une première horloge C1 et d'une seconde horloge C2, dont les impulsions sont décalées d'une demi-période T par rapport à celles de la première horloge C1.

Ce circuit numérique 20 comprend également :
- une bascule de type RS 23, commandée par le signal de départ D sur son entrée SET, et par le signal de fin d'intervalle F retardé, après passage dans le circuit 19, sur son entrée RESET ;

- un premier bloc 24 comportant :
  - un premier compteur 25,
  - une première bascule de type D 26,
  - un premier circuit ET 27 ;
- un second bloc 28 comportant :
  - un second compteur 29,
  - une seconde bascule de type D 30,
  - un second circuit ET 31 ;
- un circuit 32 doté d'une mémoire, apte à effectuer une fonction OU pour détecter laquelle d'entre les sorties des circuits 26 et 30 a basculé la première.

Dans le premier bloc 24, le premier compteur 25 reçoit sur son entrée autorisation CE un ordre de comptage venant de la bascule 23. Les données en sortie du premier compteur 25 sont transmises au circuit de traitement 22 par l'intermédiaire d'un circuit aiguillage 36 commandé par un circuit OU 32. La première bascule de type D 26 reçoit le signal F sur son entrée D et la première horloge C1 sur son entrée horloge. Le premier circuit ET 27 réalise la fonction ET de la sortie de la bascule 26 et de l'horloge C2.

Dans le second bloc 28, le second compteur 29 reçoit sur son entrée autorisation CE un ordre de comptage venant de la bascule 23. Les données de ce compteur 29 sont transmises au circuit de traitement 22 par l'intermédiaire du circuit 36. La seconde bascule de type D 30 reçoit le signal F sur son entrée D et la seconde horloge C2 sur son entrée horloge. Le second circuit ET 31 réalise la fonction ET entre la sortie de ce circuit 30 et l'horloge C1.

Le circuit 32 a sa sortie qui commande le fonctionnement du circuit aiguillage 36 pour obtenir la lecture du compteur 25 ou 29 dont la bascule de type D (26 ou 30) associée n'a pas basculée la première. Il détecte la première des bascules 26 ou 30 qui a basculé. Il autorise la lecture du compteur dont la bascule n'a pas changé d'état. Le circuit 36 est relié par une bascule 33 au circuit de traitement 22 et lui fournit les données relatives au compteur sélectionné.

Le circuit de mesure analogique 21 comprend un circuit 34 de mémorisation et de conversion en amplitude de tension suivi d'un circuit de conversion analogique/numérique 35.

Ce circuit de mesure analogique 21 est commandé par la bascule 33, apte à mesurer le temps séparant le signal de fin de délai de l'impulsion d'horloge qui lui succède. Le circuit 35 permet de convertir les données analogiques obtenues en sortie du circuit 34 en données numériques. La durée du signal à la sortie de la bascule 33 représente la partie fine de l'intervalle de temps que l'on cherche à mesurer. Cette bascule 33 commande le circuit 34 en déclenchant la rampe de montée en tension V.

La bascule 33 est une bascule RS qui reçoit sur son entrée SET le signal F retardé, sur son entrée RESET un OU connecté aux sorties des circuits ET 27 et 31. Sa sortie délivre un signal qui commande le circuit 34 et qui est arrêté par l'impulsion d'horloge suivante C1 ou C2 (horloge préalablement sélectionnée).

Le circuit de traitement 22 reçoit d'une part les données du compteur 25 ou 29 sélectionné, et d'autre part le signal de sortie de la bascule 33, converti en une tension par l'intermédiaire du circuit 34, qui est numérisée par le circuit 35.

Le fonctionnement de ce dispositif 35 est basé sur l'utilisation d'un décalage temporel contrôlé entre les actions du signal de fin de délai F sur le compteur et d'un circuit d'identification d'ambiguïté dans chacune des voies.

Les deux compteurs 25 et 29 reçoivent respectivement les signaux horloge C1 et C2 sur leurs entrées de comptage, et un signal sur leurs entrées d'autorisation CE. Les quatre bascules 26, 30, 33 et 23 de type D sont dotées de contrôles SET-RESET.

Les bascules 26 et 30 reçoivent les horloges C1, C2 et le signal F sur leurs entrées D. Leurs sorties sont respectivement mélangées sur deux circuits ET 27 et 31 avec les signaux horloge C2, C1.

L'entrée autorisation CE des compteurs est commandée par le signal F retardé par exemple d'environ 3tpd (temps de propagation). En supposant une situation d'incertitude sur le compteur 29 entre CE et C2, une telle situation ne peut exister simultanément sur la prise en compte du signal F par C2 sur la bascule 30 du fait de ce décalage temporel de 3tpd. Ainsi, la bascule 30 est activée. Le signal horloge C1 arrête le circuit 34 par l'intermédiaire du circuit ET 31. Le compteur 25, qui a travaillé en dehors de toute situation d'incertitude, est alors lu.

Dans une situation analogue sur le compteur 25, le circuit 34 est arrêté par C2 et le compteur 29 est lu.

Par ailleurs, quand il y a une situation d'incertitude sur l'un ou l'autre des circuits 26 ou 30, il en résulte un état métastable, c'est-à-dire un état indéfini variant de 0 à 1, sur sa sortie qui ne dure pas plus de quelques nanosecondes (<<T/2). C'est alors le circuit qui travaille avec l'horloge duale décalée d'une demi-période qui est activé et réalise l'aiguillage.

Ces conditions de fonctionnement sont garanties par un contrôle très précis des temps de propagation des signaux. Les circuits utilisés ont des temps de propagation, des temps d'anticipation/maintien qui sont pris en compte pour le positionnement des signaux.

Une remise à zéro des compteurs 25 et 29 est réalisée avant chaque mesure par un dispositif classique (non représenté).

Après chaque mesure les données contenues dans le circuit de traitement 22 sont transférées vers des unités comme par exemple des unités de calcul et de gestion des mesures.

Le caractère dual des deux voies de mesure est affirmé dans la topologie, le placement et la répartition des circuits dans les boîtiers. Avantageusement les bascules 26 et 30 sont situées dans un même boîtier. Les signaux horloge C1, C2 qui les commandent, traversent donc le même nombre d'opérateurs dans des boîtiers identiques. Toute dérive thermique est ainsi différentielle ment compensée. Certains circuits sont utilisés comme éléments de retard et de redistribution du signal. Les parcours des deux signaux horloge sont identiques en terme de longueur de cuivre et d'opérateurs traversés. Les lignes sont toutes à impédance définie 50 ou 100 ohms et adaptées par rapport à leur impédance caractéristique, afin d'éviter des phénomènes d'oscillation et de réflexion. Moyennant ce contrôle précis des temps dans les circuits logiques très grande vitesse utilisés, (fréquence de l'ordre du gigahertz), et des liaisons entre les circuits, on évite toute erreur sur la saisie des paramètres de la mesure.

Dans une réalisation avantageuse la pente de conversion temps/amplitude de tension est réglée de manière à ce que l'on puisse traiter dans le même mot binaire le contenu du compteur et le résultat de la conversion analogique/numérique de la sortie V du convertisseur temps/amplitude de tension. Le contenu de chaque compteur est un mot binaire dont le bit le moins significatif (ou LSB) représente par exemple dix nanosecondes. Le résultat de la conversion numérique de la conversion du temps en amplitude est un mot binaire. On règle la pente de conversion du convertisseur 34 en V/ns de telle sorte que le bit le plus significatif (ou MSB) du mot de ce convertisseur représente par exemple cinq nanosecondes. Ainsi les deux mots numériques sont adjacents et le temps d'accès au résultat est pratiquement égal au temps de conversion.

Par ailleurs, la combinaison des deux mesures numérique et analogique, qui permet de compter des intervalles de temps grands sans autre limitation que celle de la capacité d'une mémoire numérique, ne présente aucune ambiguïté et permet d'atteindre les résultats des mesures obtenues pour des intervalles de temps courts. La précision sur le temps est liée à la résolution du convertisseur 35 : dans une réalisation "soignée" du dispositif on peut atteindre une dizaine de picosecondes, performance des meilleurs instruments actuels.

Cette mesure de la durée d'intervalle de temps trouve son application dans la réalisation d'un capteur d'images pour la robotique qui requiert un grand nombre de mesures précises par seconde, mesures dites de "temps de vol", d'une impulsion laser. Le temps à mesurer est celui mis par une impulsion lumineuse pour aller et revenir d'un émetteur à un récepteur en ayant subi une réflexion sur une cible (temps de vol). On travaille alors sur l'impulsion électrique correspondant à l'impulsion lumineuse. Le circuit de mesure de temps est alors destiné à être adapté à un télémètre. Le temps est mesuré avec une précision de 20 picosecondes en un tir laser à raison d'un point de l'image par mesure. On a la relation Tmesure = durée aller/retour + temps de traitement (temps mort). L'image n'étant pas stationnaire, on effectue un tir laser par pixel.

A titre d'exemple numérique, avec un temps de conversion analogique/numérique de 100 nanosecondes on peut mesurer des temps de l'ordre de la microseconde avec une précision de 40 picosecondes et une récurrence voisine du mégahertz. Dans la réalisation d'un imageur à trois dimensions pour la robotique mobile, le dispositif de l'invention est matérialisé sur une carte électronique de 3 dm², six couches électriques avec des liaisons adaptées à impédance définie.

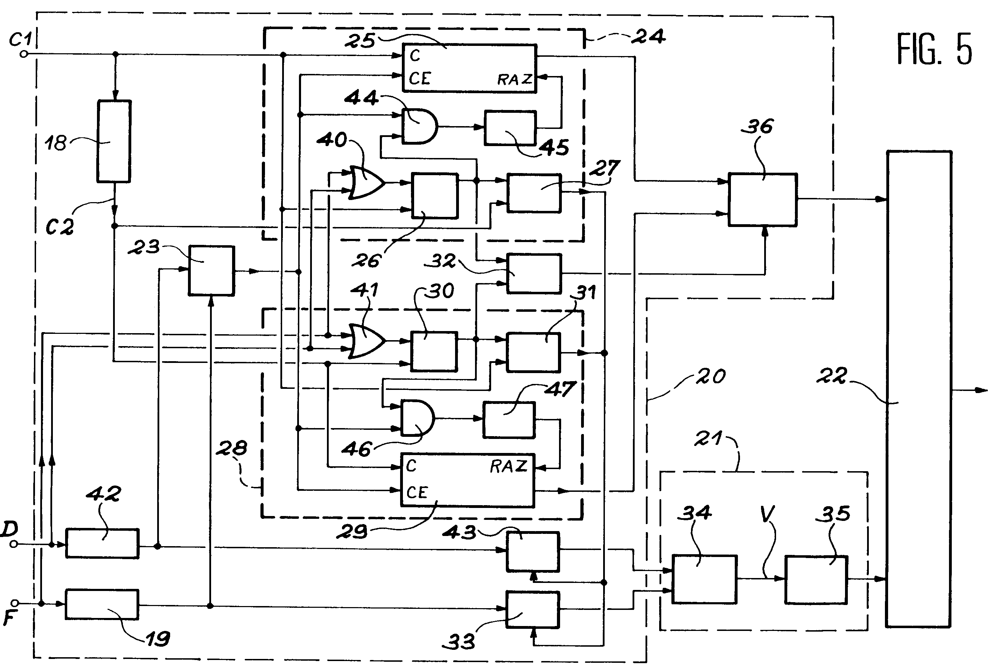

Dans une variante de réalisation de l'invention, les signaux de début D et de fin F de l'intervalle de temps à mesurer ne sont, ni l'un ni l'autre, référencés à un signal horloge, comme illustré sur la figure 4. Le signal D déclenche une décharge de la capacité du circuit 34, qui est arrêtée par l'une des impulsions d'horloge C1 ou C2. Les compteurs sont alors autorisés. De même que dans la description ci-dessus, si il y a une situation d'incertitude quant au début de comptage pour l'un ou l'autre des compteurs, le premier des circuits d'identification de présence 26 ou 30 qui bascule valide le choix entre les horloges C1 ou C2 pour arrêter la décharge de la capacité et le compteur qui a compté la première impulsion d'horloge de façon fiable.

Sur la courbe F, on a représenté deux situations de fin d'intervalle repérée par les positions F1 et F2. Sur la courbe V, V2 correspond à l'amplitude atteinte par le dispositif analogique correspondant à F2 et V1 à F1.

Ainsi dans cette variante de réalisation, on effectue une mesure de temps sans référence temporelle de départ.

Les signaux de début (D) et fin (F) de l'intervalle de temps à mesurer ne sont ni l'un ni l'autre référencés au signal horloge comme illustré sur la figure 4.

De manière à pouvoir résoudre toute situation d'incertitude sur le signal D comme cela a été fait pour le signal F, le signal D est traité de la même manière par les mêmes opérateurs. On a ainsi la variante de réalisation représentée sur la figure 5.

Les bascules D 26 et 30 reçoivent désormais les signaux D ou F par l'intermédiaire d'une fonction OU 40, 41 sur leur entrée D. La bascule 23 qui délivre le signal d'autorisation CE est également commandée par les signaux D et F tous deux retardés d'une quantité voisine de 3tpd (19, 42).

La capacité du circuit 34 est associée à deux générateurs de courant égaux et de signes opposés commandés par les bascules 33 et 43 qui sont déclenchées respectivement par les signaux D et F. Le signal D déclenche une décharge de la capacité qui est arrêtée par l'une des impulsions d'horloge $C_1$ ou $C_2$. Les compteurs sont alors autorisés.

Comme dans la description précédente, s'il y a une situation d'incertitude au début du comptage pour l'un ou l'autre des compteurs, le premier des circuits d'identification de présence 26, 30 qui bascule valide le choix entre les horloges C$_1$ ou C$_2$ pour arrêter la décharge de la capacité et le compteur qui a compté la première impulsion d'horloge de façon fiable.

Le compteur validé est laissé inchangé, par contre l'autre compteur est remis à zéro avant l'arrivée de la deuxième impulsion d'horloge suivant le signal D; ainsi son contenu est fiabilisé. Ceci est réalisé par les circuits 44, 45 et 46, 47 respectivement pour les premier et deuxième compteurs. Les circuits 44 et 46 sont des circuits ET, les circuits 45 et 47 sont des mises en forme temporelle.

Le signal F déclenche une charge de la capacité avec un courant miroir du courant utilisé préalablement à la décharge. Comme dans le dispositif précédent, il arrête les compteurs en identifiant lequel doit être lu.

La valeur du temps mesuré est donné par l'équation

$$t = (N - K)T \quad (3)$$

Si le compteur validé n'est pas le même lors du traitement des signaux D et F, l'équation à utiliser devient :

$$t = (N + 1/2 - K)T \quad (4)$$

Dès l'arrivée du signal D, la capacité est le siège d'une décharge correspondant au temps précédant le début du comptage validé, donc à ajouter au temps représenté par le contenu N du compteur. Après l'arrivée du signal F cette capacité est le siège d'une charge correspondant au temps qui précède la N plus unième impulsion du signal horloge, c'est-à-dire à soustraire au contenu du compteur. La capacité intègre ces fonctions sous réserve que sa charge n'ait pas varié entre les deux phases décharge/charge.

**Revendications**

1. Dispositif de mesure de la durée d'un intervalle de temps entre un signal de début (D) et un signal de fin (F) d'intervalle à mesurer comprenant :
   - un circuit numérique (20) muni d'une horloge C1, apte à compter le nombre d'impulsions d'horloge comprises entre le signal de début (D) et le coup d'horloge succédant au signal de fin d'intervalle (F) ;
   - un circuit analogique (21), apte à mesurer le temps séparant le signal de début d'intervalle (D) de l'impulsion d'horloge qui lui succède et à mesurer le temps séparant le signal de fin d'intervalle (F) de l'impulsion d'horloge qui lui succède et apte à convertir les données analogiques obtenues en données numériques ;
   - un circuit de traitement (22), apte à déterminer la durée de l'intervalle de temps à partir des données fournies par le circuit numérique et celles fournies par le circuit analogique préalablement converties en données numériques ;

   caractérisé en ce que le circuit numérique est muni d'une seconde horloge (C2), dont les impulsions sont décalées d'une demi-période T par rapport à celles de la première horloge (C1) et de moyens aptes à déterminer lequel des comptages réalisés sur l'une des deux horloges (C1, C2) est à prendre en compte, de manière à résoudre toute situation d'ambiguïté qui pourrait conduire à une erreur de comptage d'une période d'horloge.

2. Dispositif selon la revendication 1, caractérisé en ce que le signal de début d'intervalle est synchrone de la première horloge (C1), et. en ce que le circuit numérique (20) comprend également :
   - une bascule de type RS (23), commandée par le signal de début (D) sur son entrée SET, et par le signal de fin de délai (F) retardé, après passage dans un circuit (19) retardateur, sur son entrée RESET ;
   - un premier bloc (24) comportant :
     • un premier compteur (25),
     • une première bascule de type D (26),
     • un premier circuit ET (27) ;
   - un second bloc (28) comportant :
     • un second compteur (29),
     • une seconde bascule de type D (30),
     • un second circuit ET (31) ;
   - un circuit (32) doté d'une mémoire, apte à effectuer une fonction OU pour détecter laquelle d'entre les sorties des bascules (26 et 30) a basculé la première.

3. Dispositif selon la revendication 1, caractérisé en ce que le signal de début d'intervalle n'est pas synchrone de la première horloge (C1), et en ce que le circuit numérique (20) comprend également :
   - une bascule de type RS (23), commandée par le signal de début (D) retardé après passage dans un premier circuit (42) retardateur sur son entrée SET, et par le signal de fin de délai (F) retardé, après passage dans un circuit (19) retardateur de retard identique à celui du premier circuit retardateur sur son entrée RESET ;
   - un premier bloc (24) comportant :
     • un premier compteur (25),
     • une première bascule de type D (26),
     • un premier circuit ET (27),
     • un premier circuit OU (40,
     • un second circuit ET (44),

- un moyen de mise en forme temporelle du signal (45) ;
  - un second bloc (28) comportant :
    - un second compteur (29),
    - une seconde bascule de type D (30),
    - un troisième circuit ET (31),
    - un second circuit OU (41),
    - un quatrième circuit ET (46),
    - un moyen de mise en forme temporelle du signal (47) ;
  - un circuit (32) doté d'une mémoire, apte à effectuer une fonction OU pour détecter laquelle d'entre les sorties des bascules (26 et 30) a basculé la première.

4. Dispositif selon l'une quelconque des revendications 2 ou 3, caractérisé en ce que le circuit de mesure analogique (21) comprend un circuit (34) de mémorisation et de conversion en amplitude de tension suivi d'un circuit de conversion analogique/numérique (35).

5. Dispositif selon les revendications 2 et 4, caractérisé en ce que dans le premier bloc (24), le premier compteur (25) reçoit sur son entrée autorisation CE un ordre de comptage venant de la bascule (23) de type RS, en ce que les données en sortie du premier compteur (25) sont transmises au circuit de traitement (22) par l'intermédiaire d'un circuit aiguillage (36) commandé par un circuit OU (32), en ce que la première bascule de type D (26) reçoit le signal de fin d'intervalle (F) sur son entrée D et la première horloge (C1) sur son entrée horloge, et en ce que le premier circuit ET (27) réalise la fonction ET de la sortie de la première bascule de type D (26) et de la seconde horloge (C2).

6. Dispositif selon les revendications 3 et 4, caractérisé en ce que dans le premier bloc (24), le premier compteur (25) reçoit sur son entrée autorisation CE un ordre de comptage venant de la bascule (23) de type RS, en ce que les données en sortie du premier compteur (25) sont transmises au circuit de traitement (22) par l'intermédiaire d'un circuit aiguillage (36) commandé par un circuit OU (32), en ce que la première bascule de type D (26), commandée par un premier circuit OU (40) reçoit le signal de début et le signal de fin d'intervalle (F) sur son entrée D et la première horloge (C1) sur son entrée horloge, et en ce que le premier circuit et (27) réalise la fonction ET de la sortie de la première bascule de type D (26) et de la seconde horloge (C2).

7. Dispositif selon la revendication 5, caractérisé en ce que dans le second bloc (28), le second compteur (29) reçoit sur son entrée autorisation (CE) un ordre de comptage venant de la bascule (23) de type RS, en ce que les données de ce compteur (29) sont transmises au circuit de traitement (22) par l'intermédiaire d'un circuit d'aiguillage (36), en ce que la seconde bascule de type D(30) reçoit le signal de fin d'intervalle sur son entrée D et la seconde horloge (C2) sur son entrée horloge, et en ce que le second circuit ET (31) réalise la fonction ET entre la sortie de cette bascule D (30) et la première horloge (C1).

8. Dispositif selon la revendication 6, caractérisé en ce que dans le second bloc (28), le second compteur (29) reçoit sur son entrée autorisation (CE) un ordre de comptage venant de la bascule (23) de type RS, en ce que les données de ce compteur (29) sont transmises au circuit de traitement (22) par l'intermédiaire d'un circuit d'aiguillage (36), en ce que la seconde bascule de type D (30), commandée par un second circuit OU (41) reçoit le signal de début et le signal de fin d'intervalle sur son entrée D et la seconde horloge (C2) sur son entrée horloge, et en ce que le second circuit ET (31) réalise la fonction ET entre la sortie de cette bascule D (30) et la première horloge (C1).

9. Dispositif selon l'une quelconque des revendications 7 ou 8, caractérisé en ce que le circuit doté d'une mémoire (32) a sa sortie qui commande le fonctionnement du circuit aiguillage (36) pour obtenir la lecture du compteur (25 ou 29) dont la bascule de type D (26 ou 30) associée n'a pas basculée la première, en ce que ce circuit (36) est relié au circuit de traitement (22) et lui fournit les données relatives au compteur sélectionné.

10. Dispositif selon la revendication 9, caractérisé en ce que la bascule (33) est une bascule de type RS qui reçoit sur son entrée SET le signal de fin d'intervalle (F) retardé, et sur son entrée RESET un circuit OU connecté aux sorties des circuits ET(27, 31), et en ce que sa sortie délivre un signal au circuit (34) de mémorisation et de conversion en amplitude de tension.

11. Dispositif selon la revendication 2, caractérisé en ce que le circuit analogique comporte un circuit de mémorisation (34) qui comprend :
    - un générateur apte à fournir un courant ;
    - un condensateur ;
    - interrupteurs aptes à commuter le courant issu du générateur sur le condensateur et qui est commandé par la bascule de type RS (33), recevant le signal de fin d'intervalle retardé sur son entrée SET et le signal de début d'intervalle sur son entrée RESET.

**12.** Dispositif selon la revendication 3, caractérisé en ce que le circuit analogique comporte un circuit de mémorisation (34) qui comprend :
- deux générateurs aptes à fournir des courants égaux en amplitude et de signes opposés ;
- un condensateur ;
- deux interrupteurs aptes à commuter les courants issus des deux générateurs sur le condensateur et qui sont commandés par les bascules de type RS (33 et 43) recevant pour RS (33), le signal de fin d'intervalle retardé sur son entrée RESET et pour RS (43), le signal de début d'intervalle retardé sur son entrée SET et le OU connecté sur son entrée RESET.

**13.** Dispositif selon la revendication 11, caractérisé en ce que le signal de fin d'intervalle (F) est retardé d'un délai de 3tpd (tpd=temps de propagation).

**14.** Dispositif selon la revendication 12, caractérisé en ce que les signaux de début et de fin d'intervalle sont retardés d'un délai égal de 3 tpd.

**15.** Dispositif selon l'une quelconque des revendications précédentes, caractérisé en ce qu'il est utilisé pour la réalisation d'un capteur d'images pour la robotique qui requiert un grand nombre de mesures précises par seconde, mesures dites de "temps de vol", d'une impulsion laser, le temps à mesurer étant celui mis par une impulsion lumineuse pour aller et revenir d'un émetteur à un récepteur en ayant subi une réflexion sur une cible (temps de vol).

FIG. 1

FIG. 2

FIG. 4

FIG. 3

FIG. 5

EP 0 632 279 A1

Office européen
des brevets

# RAPPORT DE RECHERCHE EUROPEENNE

Numero de la demande

EP 94 40 1492

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| Y | EP-A-0 448 182 (SUNDSTRAND) *résumé* | 1 | G01R29/027 |
| Y | EP-A-0 077 075 (HITACHI) * page 4, ligne 23 - page 5, ligne 7; figures 7,18 * | 1 | |
| A,D | IEEE TRANSACTIONS ON NUCLEAR SCIENCE, vol.NS-20, no.5, Octobre 1973 pages 36 - 51 PORAT 'review of sub-nanosecond time interval measurements' | | |
| A,D | PROCEEDINGS OF THE IRE, vol.45, 1957, NEW YORK,US pages 21 - 30 BARON 'the vernier time-measuring tecnique' | | |

|  |  | DOMAINES TECHNIQUES RECHERCHES (Int.Cl.6) |
|---|---|---|
|  |  | G01R |

Le présent rapport a été établi pour toutes les revendications

| Lieu de la recherche | Date d'achèvement de la recherche | Examinateur |
|---|---|---|
| LA HAYE | 30 Août 1994 | Hoornaert, W |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)